Europäisches Patentamt

European Patent Office

Office européen des brevets

(19)

(11) Publication number: **0 097 380**
**A2**

# EUROPEAN PATENT APPLICATION

(12)

(21) Application number: **83106381.3**

(22) Date of filing: **13.03.80**

(51) Int. Cl.³: **G 03 B 41/00**
**G 05 D 3/00**

(30) Priority: **02.04.79 US 25917**

(43) Date of publication of application:
**04.01.84 Bulletin 84/1**

(84) Designated Contracting States:
**DE FR GB IT**

(60) Publication number of the earlier application
in accordance with Art. 76 EPC: **0 017 044**

(71) Applicant: **Optimetrix Corporation**
**500 Ellis Street**
**Mountain View California 94043(US)**

(72) Inventor: **Phillips, Edward H.**
**P.O.Box 1042**
**Middletown, CA 95461(US)**

(74) Representative: **Liesegang, Roland, Dr.-Ing.**
**Sckellstrasse 1**
**D-8000 München 80(DE)**

(54) A system for positioning a utilization device.

(57) A system for positioning a utilization device (33, 105), which forms part of an optical imaging system, parallel to a selected plane (X-Y), comprises a base structure (101), a plurality of spaced drive means (237-255) for supporting the utilization device (33, 105) for translational movement along a first axis (Z) normal to a plane (X-Y) of the base structure (101) and for rotational movement about second and third axes (X, Y) orthogonal to the first axis (Z) and parallel to said plane (X-Y) of the base structure (101); and constraining means (283, 297, 299), including the drive means (237-255), for kinematically constraining the utilization device (33, 105) to move only along the first axis (Z) and about the second and third axes (X, Y).

The system may be applied for instance to position the small plane of a projection lens of said optical imaging system to achieve precise focusing of the surface of a simiconductive wafer.

Fig 1

**Dr.-Ing. Roland Liesegang**

Patentanwalt
European Patent Attorney

Sckellstrasse 1
D-8000 München 80
Telefon (089) 4 48 24 96

Telex 5214382 pali d
Telekopierer (089) 272 04 80, 272 04 81
Telegramme patemus münchen

Postscheck München 394 18-802
Hypobank München 6 400 194 333
Reuschelbank München 2 603 007

OPTIMETRIX CORPORATION

Mountain View, USA

EU 140 29

A system for positioning a utilization device

This invention relates generally to a system for positioning a utilization device, which forms part of an optical imaging system parallel to a selected plane, said system including a base structure. An example for such a system is an optical focusing systems of the type utilizing a reduction lens system for photometrically printing an image of a first object such as a reticle upon a second object such as a semiconductor wafer and, more specifically, to apparatus utilized in such systems to achieve precise focusing or positioning of the top surface of the wafer at the image plane of a projection lens of the lens system.

In the following description a system as described above is cited as "a system of the kind specified."

In the semiconductor industry, reduction lens systems are employed in the fabrication of photomasks to print an array of microcircuitry on each photomask. A set of such photomasks, each bearing an array of microcircuitry of a different level, is typically employed in the fabrication of integrated circuits from a semiconductive wafer. In the course of this fabrication, the semiconductive wafer is sequentially aligned with each photomask and a contact exposure is made at each processing level to print the array of microcircuitry on the photomask onto the semiconductive wafer. Alternativeley, similar reduction lens systems may be directly employed in an exposure operation to initially print the array of microcircuitry directly upon the semiconductive wafer rather than the photomask, thereby eliminating the photomask step entirely. In either case, the top surface of either the photomask or the wafer must be precisely focused, automatically, at the image plane of the projection lens of the lens system. In practice, however, precise focus of semiconductive wafers is very difficult to achieve because of surface irregularities present in the surface of the unprocessed (unexposed) wafer or introduced as a result of various processing steps, resulting in mottled exposure of photoresist and unresolved microcircuit images formed upon the wafer.

Known prior-art systems do not adequately provide for detection of focus error due, for example, to imprecise focusing of the image plane of the projection lens at the edges of the exposure (i. e., at the edges of the portion of the wafer being exposed, which edges are sometimes not in the same horizontal plane as the center of the wafer). One such system is described, for example, in U. S. Patent No. 3,722,996 entitled OPTICAL PATTERN GENERATOR OR REPEATING PROJECTOR OR THE LIKE issued March 27,1973, to Wayne L. Fox. Other prior-art systems also do not adequately provide for detection of focus error because they often utilize sample areas which are too small ( e.g., extremely small sample areas of about 10 microns in diameter are generally used). One such system is described for example in U. S. Patent No. 4,128,847 entitled OPTICAL READING DEVICE COMPRISING A FOCUSING DETECTION DEVICE issued December 5, 1978 to Gerald Roullet and Jean-Pierre Bortuzzo.

What would be useful in providing improved microcircuit exposures, therefore, is a system that would be capable of detecting when a selected portion of a wafer, even a portion close to an edge of the wafer, is out of focus due to variations in thickness or flatness of the wafer or other factors, and capable of correcting said out-of-focus condition by bringing the selected portion into focus prior to exposure. Also, to increase the utility of such a system, and hence the production of microcircuits, it would be desirable that the system be ruggedly constructed and not subject to small variations in environmental factors such as temperature as are many prior-art systems.

Accordingly, it is the principal object of this invention to provide a system for accurately positioning a utilization device, which forms part of an optical imaging system, parallel to a selected plane. In particular the system should be capable of accurately focusing wafer surfaces despite non-parallel, and otherwise non-flat conditions of a wafer surface.

Another object of this invention is to provide a system of the kind specified incorporating a full aperture focus detection apparatus capable of accurately detecting the focus condition of a wafer surface despite non-parallel and otherwise non-flat conditions of the wafer surface.

Another object of this invention is to provide a system of the kind specified incorporating a full aperture

- 4 -

0097380

focus detection apparatus capable of accurately detecting the focus condition of a wafer surface utilizing the existing projection lens included in the associated exposure system.

Another object of this invention is to provide a system of the kind specified incorporating a full aperture focus detection apparatus capable of accurately detecting the focus condition of a wafer surface while the associated exposure system is operational.

Another object of this invention is to provide a system of the kind specified incorporating a full aperture focus detection apparatus capable of accurately detecting the focus condition of a wafer surface despite differences in reflectivity of different portions of the wafer surface.

Another object of this invention is to provide a system of the kind specified incorporating a lens positioning apparatus that may be ruggedly handled without damage to the system.

Another object of this invention is to provide a system of the kind specified incorporating a lens positioning apparatus capable of restraining five degrees of freedom of movement and permitting precise, unrestrained movement in the sixth degree of freedom.

Another object of this invention is to provide a system of the kind specified incorporating a lens positioning apparatus permitting the system to be virtually perturbation free in the directions in which the system is constrained.

Another object of this invention is to provide a system of the kind specified incorporating a wafer chuck
differential leveling apparatus capable of leveling
the chuck to compensate for non-parallel conditions
of a wafer.

These objects are accomplished by providing a system
of the kind specified which comprises according to
the invention a plurality of spaced drive means for
supporting the utilization device for translational
movement along a first axis normal to a plane of the
base structure and for rotational movement about second
and third axes orthogonal to the first axis and parallel
to said plane of the base structure; and constraining
means, including the drive means, for kinematically
constraining the utilization device to move only along
the first axis and about the second and third axes.

In a preferred embodiment of the invention the system
comprises a full aperture focus detection apparatus,
a lens positioning apparatus, and a wafer chuck dif-
ferential leveling apparatus. The full aperture focusing
apparatus detects the focus condition of wafers relative
to the image plane of a projection lens in the lens
positioning apparatus, and actuates the lens positioning
apparatus and/or the wafer chuck differential leveling
apparatus, to correct for an out-of-focus condition
of the wafer and to accurately focus the surface of
the wafer. In response to this actuation, the lens
positioning apparatus makes coincident the image plane
and the top surface of the wafer, and the wafer chuck
differential leveling apparatus corrects for a non-
parallel condition of the wafer surface by bringing
discrete surface regions of interest into a common
plane, namely the image plane of the lens.

Apart from the preferred embodiment, which will be described in more detail in the following description the system of the invention may be used in any applications in which accurate parallel positioning of a utilization device with respect to a reference plane is needed.

## Brief Description of the Drawings

Figure 1 is a right side view of the optical focusing system in accordance with the preferred embodiment of the present invention.

Figure 2A is a combined block and schematic diagram showing a full aperture focus detection apparatus included in the system of Figure 1.

Figures 2B, 2C, 2D and 2E are perspective and schematic diagrams showing selected optical and circuit elements included in the apparatus of Figure 2A.

Figure 3 is a graphic illustration of reflection of light from a wafer, the focus condition of which is detected by the apparatus of Figure 2A.

Figure 4 is a block diagram of a pair of matched detectors included in the apparatus of Figure 2A, and a graphic illustration of reflected light incident upon the detectors.

Figure 5 is a combined block diagram and perspective view showing an alternative embodiment of the apparatus of Figure 2A.

Figure 6 is a graphic illustration of reflection of light from a wafer, the focus condition of which is detected by the apparatus of Figure 5.

Figure 7 is a diagrammatic illustration of illuminated areas of a wafer surface produced by the apparatus of Figure 5.

Figure 8 is a perspective view showing another alternative embodiment of the apparatus of Figure 2A.

Figure 9 is a right side view of a lens positioning apparatus included in the system of Figure 1.

Figures 10A and 10B are front and right side views respectively illustrating the action of air bearings included in the apparatus of Figure 9.

Figure 11 is a graphic illustration of the directions in which the apparatus of Figure 9 is constrained from moving.

Figure 12 is an auxiliary view of a drive portion of the apparatus of Figure 9.

Figure 13 is a side view of a non-parallel wafer which the system of Figure 1 is able to detect and compensate for in focusing and chuck leveling.

Figure 14 is a graphic illustration of the action of a wafer chuck differential leveling apparatus included in the system of Figure 1 for compensating for wafer surface irregularity as shown in Figure 13.

Figure 15 is a top plan view of a leveling element included in the apparatus of Figure 14.

Figure 16 is a bottom plan view of another leveling element included in the apparatus of Figure 14.

Figure 17 is a top perspective view showing the elements of Figures 15 and 16 combined, and other selected elements of the apparatus of Figure 14 including drive means, eccentric means and constraining means.

Figure 18 is a perspective view of a distance measuring transducer or repositioning device utilized with the apparatus of Figure 9.

Figure 19 is a perspective view showing the constraining means of the apparatus of Figure 14 in greater detail.

Figure 20 is a side view of a leveled but non-flat wafer which the system of Figure 1 is able to detect and compensate for in focusing.

## Description of the Preferred Embodiment

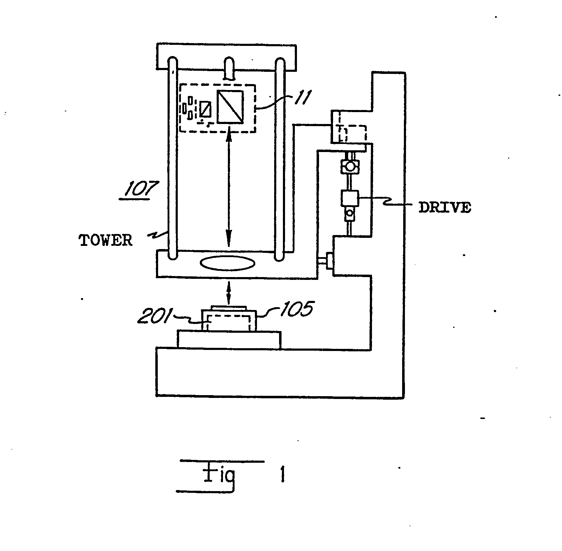

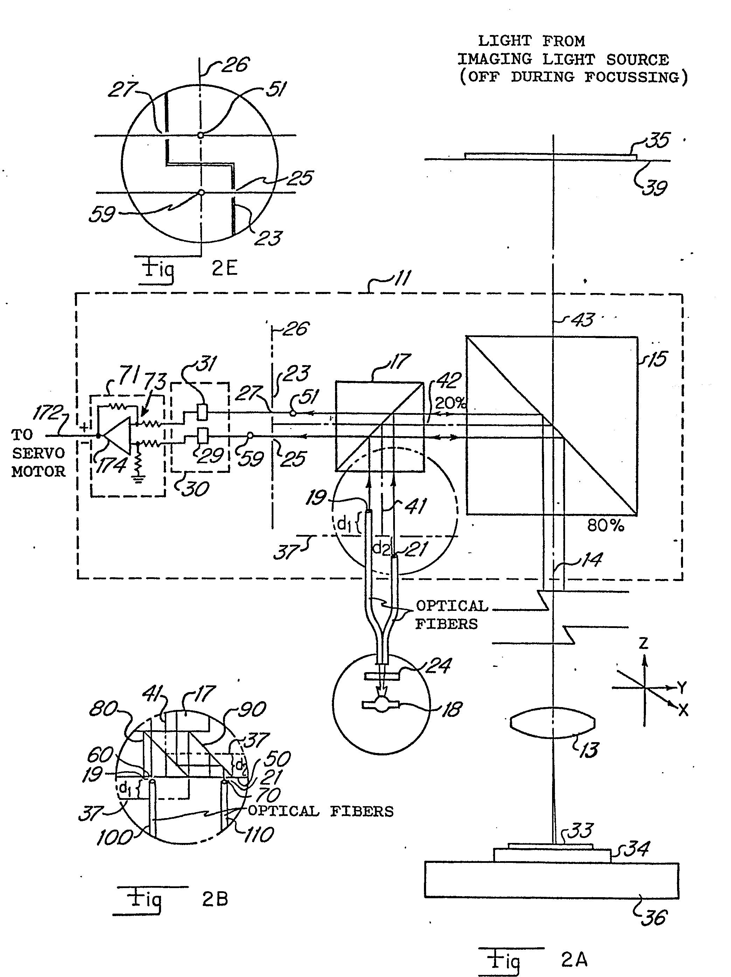

Referring now to Figure 1 of the drawings, there is shown an optical focusing system comprising a full aperture focus detection apparatus 11, a lens positioning apparatus 107 having a tower portion and a drive portion, and a wafer chuck differential leveling apparatus 201. Figure 2A shows focus detector apparatus 11 in greater detail. Focus detector 11 operates in conjunction with a 10:1 projection lens 13 of lens positioning apparatus 107 (described hereinafter) and comprises a first beam splitter 15, a second beam splitter 17, at least two focusing light sources 19, 21, an opaque aperture plate 23 with at least two selected small apertures 25, 27, at least two matched differential diode detectors 29, 31 (e.g., detectors such as the two active areas of bi-cell detector Model No. PIN SPOT/2D commercially available from United Detector Technology Corporation of Santa Monica, California), and control circuit 71. The focusing light sources 19, 21 may be, for example, fiber optic light sources capable of receiving and transmitting light from a light source such as a mercury lamp 18, the diameters of light sources 19 and 21 being, for example, $100\mu$, with the light from mercury lamp 18 passing through a filter 24 to eliminate light of such wavelengths as would cause premature, unwanted exposure of wafer 33. Focusing light sources 19, 21 are each disposed a selected short equal distance $d_1$, $d_2$ (e.g., $d_1 = d_2 = 0.109$ inches) in front of and behind an

imaginary re-image plane 37 where re-image plane 37 and object plane 39 (lower surface of reticle 35) are optically equidistant (e.g., 4.25 inches along respective light paths 41, 42 and 43) from the center of beam splitter 15. Likewise, aperture plate 23 is positioned at alternate re-image plane 26, the alternate re-image plane 26 and re-image plane 37 being optically equidistant (e.g., 1.50 inches) from the center of beam splitter 17. Beam splitter 15 is an 80-20 beam splitter, passing 80 percent of the light from the object or reticle plane and reflecting 20 percent of the light incident from path 42. Beam splitter 17 is a 50-50 beam splitter, reflecting 50 percent of the light passing along path 41 from light sources 19, 21 and passing 50 percent of the light returning along path 42 from beam splitter 15.

To ensure faithful reproduction (imaging) upon wafer 33 of a microstructure or object contained on reticle 35 when light from an imaging or primary light source is incident upon reticle 35 (which light is turned off or shuttered-out during focusing), the top or upper surface of wafer 33 must be brought into focus at the image plane of projection lens 13 (i.e., the plane at which light from projection lens 13 comes into sharp focus, within the depth of focus of the projection lens, which depth of focus is for example ± 1 micron). To bring the wafer into focus, the extent to which it may be out of focus must first be determined or detected (i.e., a signal indicative of the magnitude and direction of the extent to which it is out of focus must first be generated). This detection (signal generation) is accomplished by focus detector 11 (utilizing light from focusing light sources 19, 21), with light (along light path 43) from the imaging light source having been turned off or shuttered-out.

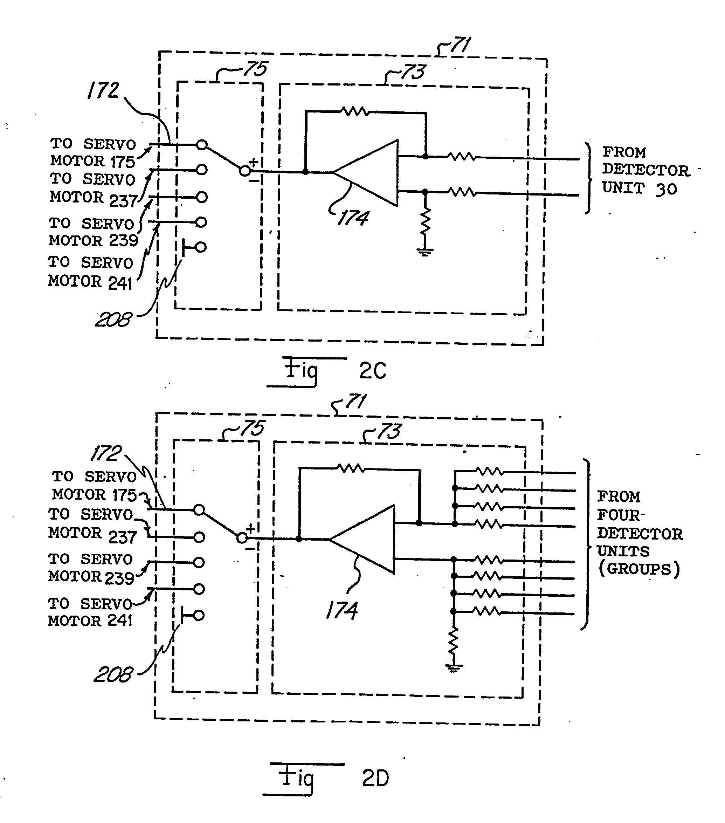

As shown in Figures 2A and 3, a portion of the light from focusing light source 19, traveling via beam splitters 17 and 15 (which light would be focused, in the absence of wafer 33, at the distance $d_3$ behind the image plane 45 of lens 13), is reflected from wafer 33 to form a real image 47 at imaginary plane 49. A portion of the light corresponding to this real image is then reflected back via lens 13 and beam splitters 15 and 17, to form another real image 59 upon passage through aperture 25 of aperture plate 23, the diameters of apertures 25 and 27 being, for example, 100µ, sufficiently sized to let a selected small amount of light through. On the other hand, light from focusing light source 21, traveling via beam splitter 17 and 15 becomes focused and forms a real image 53 at plane 55 located a distance $d_3$ above image plane 45 of lens 13. The light forming real image 53 thus has to travel an additional distance $d_5$ in order to be reflected from the surface of wafer 33. A portion of the light corresponding to this real image 53 (or virtual image 57) is then reflected back, via lens 13 and beam splitters 15 and 17, to form another real image 51 before aperture 27 of aperture plate 23.

Thus, as shown in Figure 4, if after being reflected from wafer 33, light from light sources 19, 21 becomes re-focused (re-imaged) at significantly different distances from aperture plate 23 due to the out-of-focus position of wafer 33, unequal amounts of light will pass through apertures 25 and 27 to become detected by differential diode detectors 29, 31. Upon detecting this difference in the amount or intensity of light, detectors 29, 31 generate current signals, the difference of which is proportional to this difference in the amount or intensity of light and, hence, to the extent to which wafer 33 is distant or "out-of-focus" from the image plane 45 of projection

lens 13. Thus, it may be seen that light of equal intensity goes through aperatures 25, 27 only if the images (i.e., the images of light source 21 reflected from wafer 33) become focused symmetrically on opposite sides of aperture plate 23. If these images are not equidistant but displaced an unequal distance from aperture plate 23 (i.e., displaced by an error in the axial focus position of the wafer), a differential amount of light will be detected by differential diode detectors 29, 31 and a differential control signal will be generated and amplified by a differential power amplifier circuit 73 of control circuit 71 and, as shown in Figure 2C, will be applied (as a DC level, of positive or negative polarity) via switch 75 to select servo motors 237, 239, or 241 as hereinafter described, or to select a Z-axis servo drive unit 175 (see Figure 12) for moving projection lens 13 (actually, for moving a tower structure enclosing lens 13 in a vertical direction parallel to optical axis 14) relative to wafer 33 to focus the top surface of wafer 33 at the image plane of the projection lens 13. The magnitude of the differential signal is proportional to and, hence, indicates the extent to which lens 13 is to be moved by servo unit 175 in order to be in focus, and the polarity of the signal indicates the direction in which lens 13 should be moved to bring wafer 33 into focus at the image plane of lens 13.

Thus, when the intensity of light striking detector 29 from aperture 25 is less than the intensity of light striking detector 31 from aperture 27, differential power amplifier circuit 73 produces a differential signal having a negative polarity (indicating that wafer 33 lies between lens 13 and image plane 45) causing projection lens 13 to be moved away from wafer 33, and the top surface of wafer 33 to be brought into focus at image plane 45. Conversely, when
the intensity of light striking detector 29 from aperture 25 is
greater than the intensity of light striking detector 31 from
aperture 27, differential power amplifier circuit 73 produces a differential signal
having a positive polarity (indicating that wafer 33 lies beyond
image plane 45) causing projection lens 13 to be moved toward
wafer 33 to bring the wafer into focus at image plane 45.

Figure 5 shows a more sophisticated version of full aperture
focus detection apparatus 11. Whereas the apparatus of Figure
2A utilizes only a small portion of the area of semiconductive
wafer 33 for reflecting each of the beams of light from focusing
light sources 19 and 21, the apparatus of Figure 5 utilizes a
much larger area of the wafer surface to reflect light so as to
compensate for differences in reflectivity of different areas
of the wafer surface. For example, the reflecting area used by
the apparatus of Figure 2A is approximately 30μ (thirty microns)
in diameter, or approximately $700u^2$ in area, the center-to-center
distance being, for example, 25μ. Thus, as may be expected,
there will be little, if any, overlap of the reflective zones
(reflecting area) when the apparatus of Figure 2A is utilized.
However, because the reflectivity of the wafer surface varies
across the microstructure patterns already formed in the
semiconductive wafer, it will be appreciated
that the differential signal generated by detectors 29 and 31
may be influenced undesirably by such microstructure irregularities.

As may be seen from Figure 3, the dominant factor relating
to the size of the reflecting area on wafer 33 is the distance
between imaginary planes 49, 55 and wafer surface 33. Therefore,
as shown in Figure 5, by moving sources 19, 21 away from re-image
plane 37 to positions $d_1$ in front of and behind new imaginary

-11-

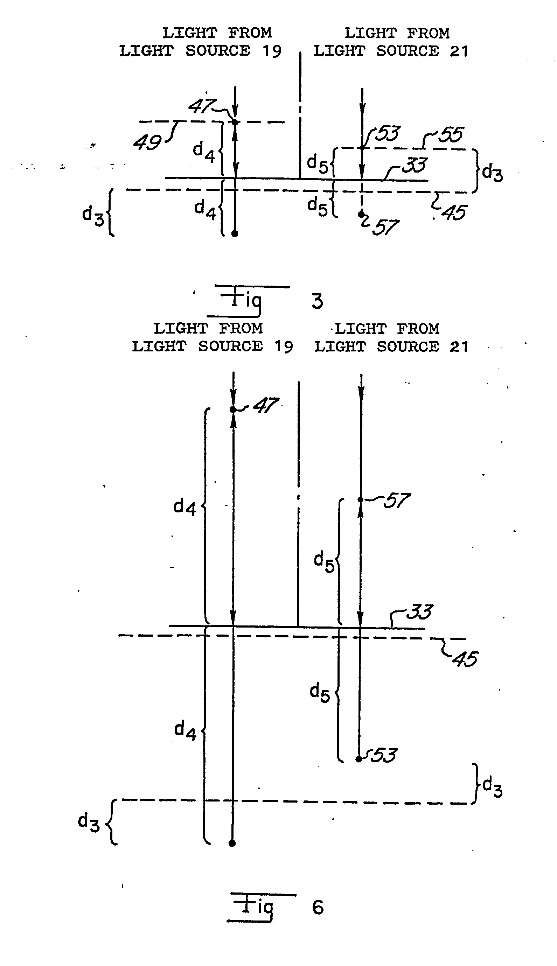

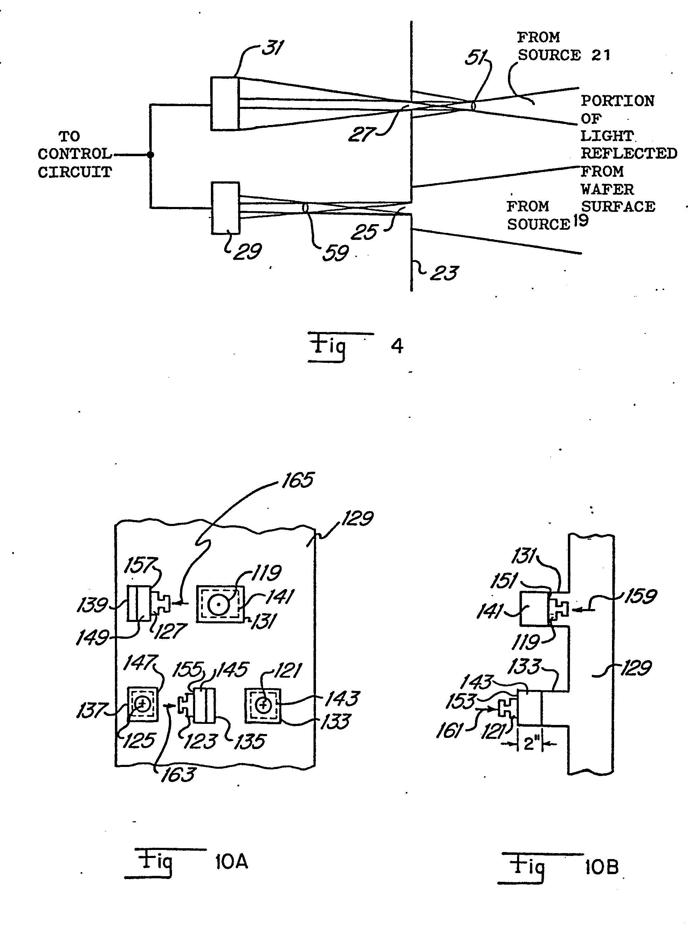

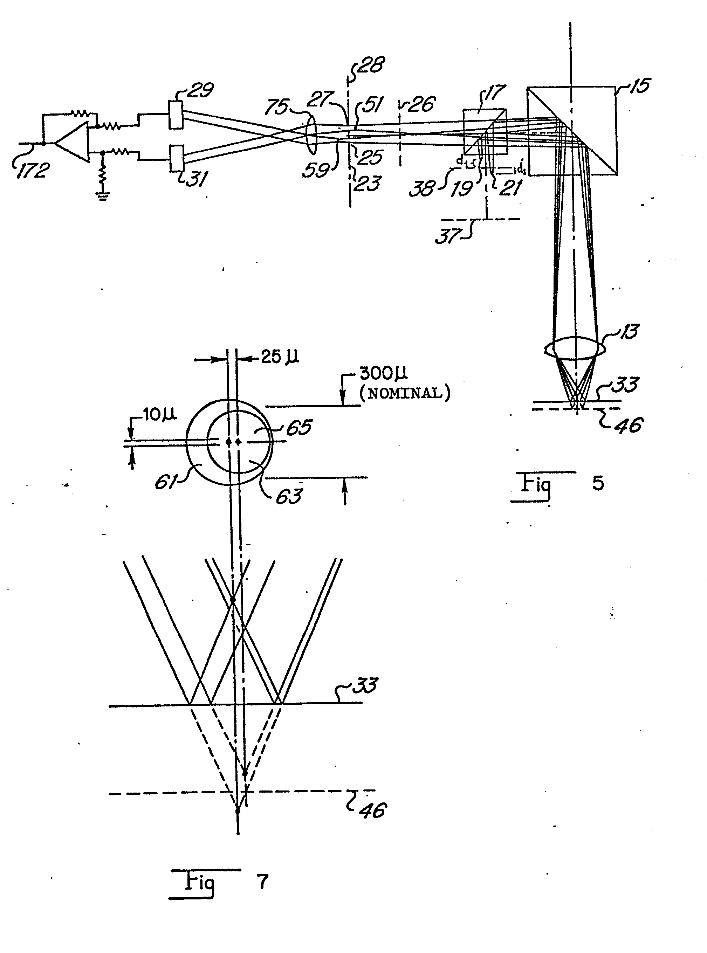

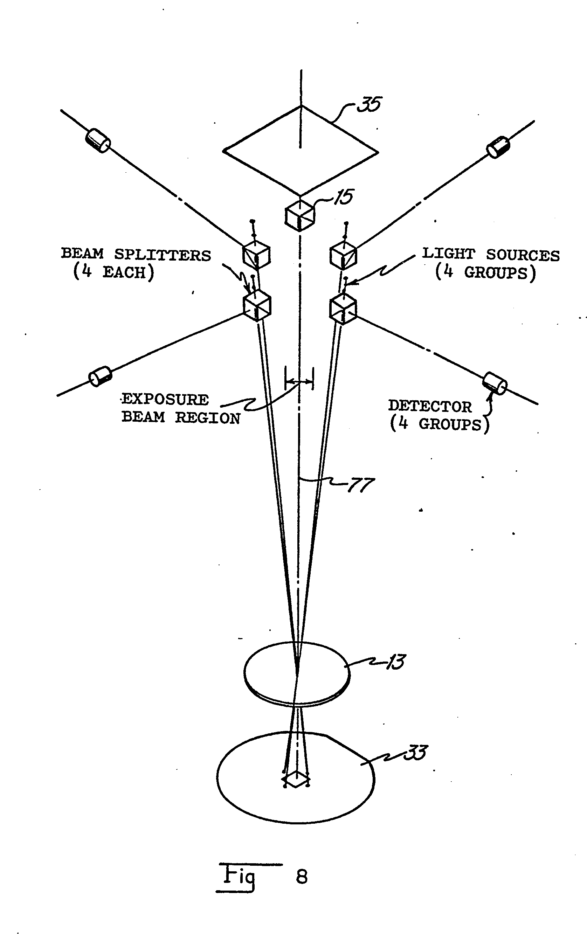

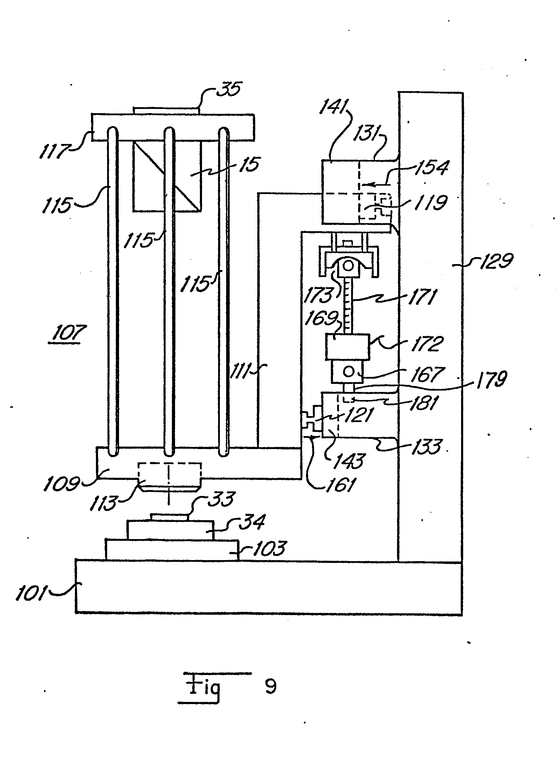

plane 38, image points 47 and 53 become significantly displaced from wafer surface 33 as shown by Figures 6 and 7, resulting in significantly larger areas of wafer surface 33 (e.g., regions 61, 63 having about 300 μ diameter or approximately 70,000 $\mu^2$ area) being utilized for reflecting the beams of light from sources 19 and 21. Because the distance between centers of the reflecting areas utilized by the apparatus of Figures 2A and 5 does not change (but remains approximately 25μ as shown in Figure 7), it may be seen from Figure 7 that the reflecting areas can be made to overlap significantly (by about 89 percent) when the apparatus of Figure 5 is utilized. Thus, if one portion of common illuminated area 65 had a level of reflectivity different from that of another portion of the same area, this would not result in different intensities of reflected light reaching the detectors.

It may be appreciated that in apparatus 11 of Figure 2A, apertures 25, 27 may be symmetrically displaced about re-image plane 26 rather than light sources 19, 21 being symmetrically displaced about re-image plane 37, as shown in Figure 2E. Alternatively, both the apertures 25, 27 and the light sources 19, 21 may be symmetrically disposed about re-image planes 26 and 37 as shown in Figures 2E and 2A, respectively, with no difference in the function of apparatus 11. To maintain the operation of detectors 29 and 31 the same in Figure 5 as shown in Figure 4 when light sources 19, 21 are moved from plane 37 to plane 38 as shown in Figure 5, a new location, namely plane 28, is specified for aperture plane 23, plane 28 being beyond alternate re-image plane 26.

It may also be appreciated that utilizing more than two pairs of light sources in front of and behind plane 38 (shown in Figure 5), together with correspondingly more pair of apertures

-12-

and detection diodes, will provide further improvement in this net overlap technique (i.e., will provide a greater percentage of overlap, which further lessens the likelihood of error in detection due to differences in reflectivity of different areas of the wafer surface). Such an apparatus with additional light sources, apertures and detection diodes, though not illustrated, is also within the scope of this invention.

Figure 2B shows an alternative arrangement of light sources 19, 21 in the system of Figure 2A. Figure 2B also shows an aperture plate 50 having precisely sized holes 60, 70 (e.g., holes 100 $\mu$ in diameter corresponding to the diameter of the fiber optic light sources 19, 21, as shown in Figure 2A, used to fix or estab- lish the size of the beams of light emitted from oversized (relative to holes 60, 70) optical fibers 100, 110, which holes are also used (in conjunction with a beam splitter 80 and a beam bender 90 described below) to precisely fix or locate the light sources with respect to optic axis 41. Beam splitter 80 and beam bender 90 permit the locating of lights 19, 21 proximate to aperture plate 50 for purposes of sizing yet retaining the distances $d_1$ and $d_2$ from re-image plane 37.

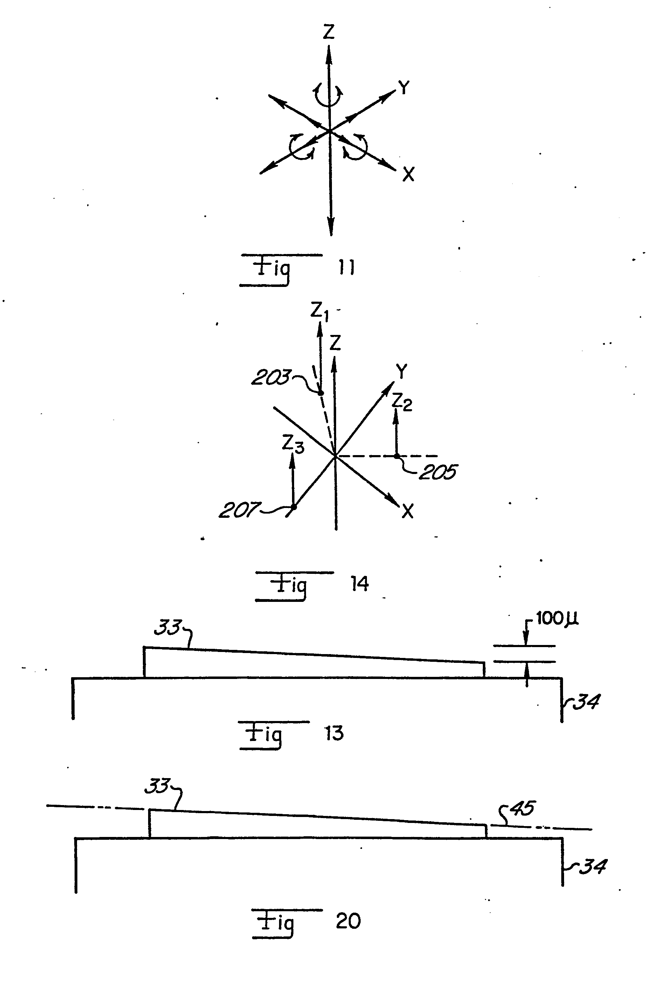

Figure 8 illustrates an alternative embodiment of the present invention where the light sources and detection elements are located below beam splitter 15 (and outside the exposure beam region). This permits the light path from the focusing light sources to aperture plane 33 to be made significantly longer, resulting in much larger reflecting areas (e.g., 700,000 $\mu^2$). This alternative arrangement obviates the need for beam splitter 15 (beam splitter 15 is therefore not included in detection apparatus 11) and, consequently, eliminates the light loss occasioned by the two 20 percent reflections performed by beam splitter 15. In Figure 8, four sets of light sources and detection apparatus are utilized, each equidistant from optic axis 77, outside of the active exposure beam region. With the apparatus of Figure 8, wafer 33 is determined to be in focus when the output signals from the detectors are averaged to zero by amplifier circuit 73 (Figure 2D) of control circuit 71. Because the detectors in Figure 8 are outside of the exposure beam region, the system may remain active and the shutter associated with the imaging light source need not be closed during focusing operations. In addition, differential output signals produced by the various groups of detectors are used to optimally level the exposure plane (the top surface of wafer 33) as described hereinafter.

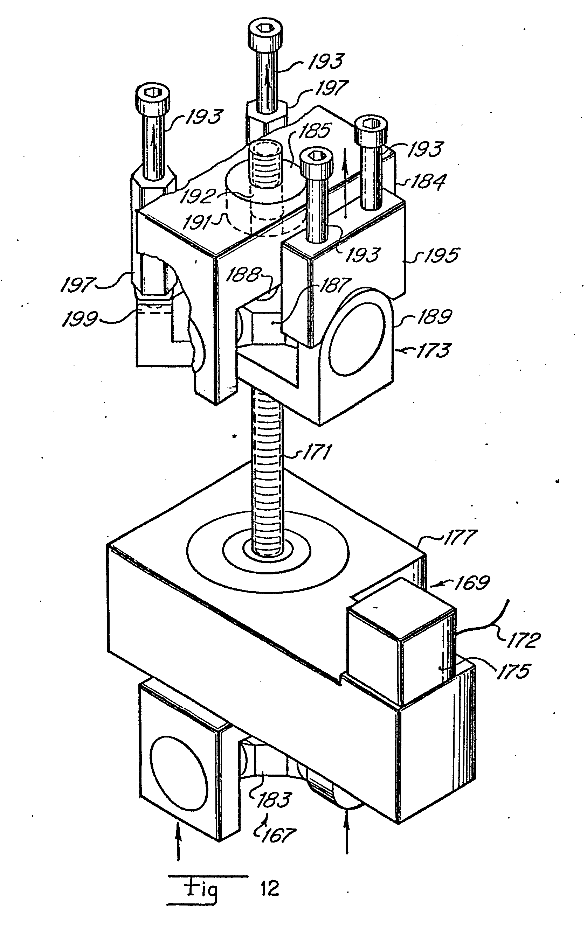

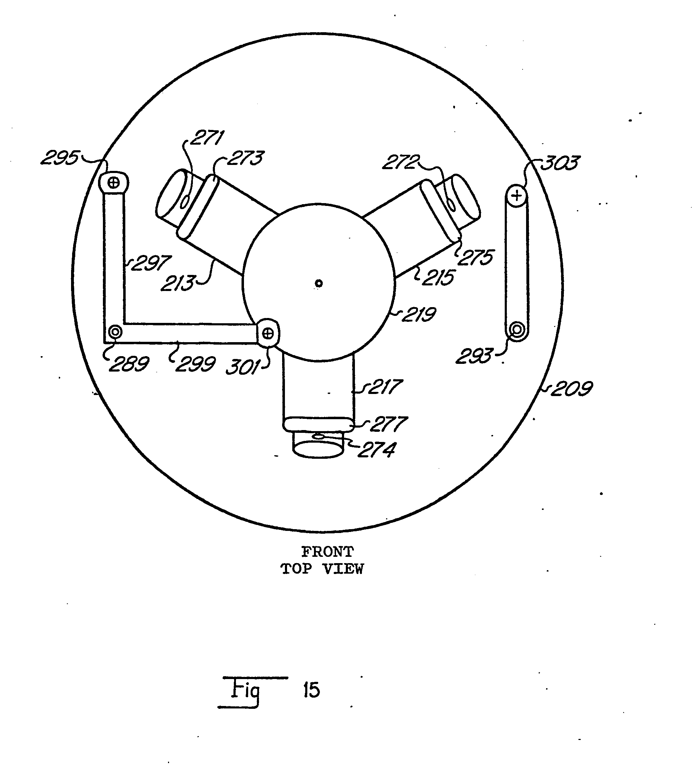

Turning now to the lens positioning apparatus included in the system of the present invention, there is shown in Figure 9 a fixed granite block 101, a stage 103 and a chuck 34 supporting wafer 33. Immediately above wafer 33 is lens positioning apparatus 107 including a tower portion comprising a base 109, a vertical member 111 extending from the base, a projection lens enclosure 113 including lens 13 (not shown), and a set of six substantially vertical bars (three shown) 115. Each of these bars 115 has one end affixed (e.g., bolted) to the base 109 and the other end similarly affixed to a top member or reticle holder 117, which holder also supports beam splitter 15 and reticle 35. Also included in the tower portion of the lens positioning apparatus 107 are five air bearings 119, 121, 123, 125, and 127 disposed as shown in Figures 9, 10A and 10B for

-14-

permitting vertical (translational) movement along the Z-axis only. Of the six degrees of freedom shown in Figure 11, translational movement along the X and Y axes and rotational movement about the X, Y and Z axes are constrained by the air bearings located as shown in Figures 9, 10A and 10B. Air bearings 119, 121, and 125 act to prevent translational movement along the Y axis and rotational movement about the X and Z axes. Air bearings 123 and 127, shown in Figure 10A, act to prevent translational movement along the X axis and rotational movement about the Y axis. Thus, only translational (vertical) movement along the Z axis is not constrained.

As shown in Figure 9, a cast iron casting 129 operates as a support structure for lens positioning apparatus 107. Casting 129, which for example weighs approximately 180 pounds, is rigidly affixed (by means of anchor bolts, not shown) to granite block 101. The casting 129 extends vertically from the rear of block 101 in a manner parallel to optic axis 14 (Figure 2A). Extending horizontally from the front of casting 129 (as best shown in Figures 10A and 10B) are five supports 131, 133, 135, 137, and 139 for five precision blocks 141, 143, 145, 147, and 149, which are lapped and adjusted (e.g., by means of an autocollimator) to have flat vertical faces on which the air bearings may ride (e.g., air bearings 119, 121, 123, and 127 ride respectively on flat faces 151, 153, 155, and 157). The weight of lens positioning apparatus 107 loads the bearings with the translational forces indicated by arrows 159, 161, 163, and 165. As shown in Figures 9, 10A, and 10B, a translational force is exerted on bearing 119 in the direction indicated by arrow 159, a translational force is exerted on bearings 121 and 125 in the direction indicated by arrow 161, a translational force is exerted on bearing 123 in the direction indicated by arrow 163, and a translational force is exerted on bearing 127 in the direction indicated by arrow 165.

As shown in Figure 9 and 12 lens positioning apparatus 107 also includes a drive portion comprising a first or lower universal joint assembly 167, servo motor drive and gear box assembly 169, a ball screw 171, and a second or upper universal joint assembly 173 upon which vertical member 111 of the tower portion of apparatus 107 is supported for vertical movement of the tower portion with respect to vertical column or casting 129. Motor drive assembly 169, which includes servo motor unit 175 and gear assembly 177, is mounted upon universal lower joint assembly 167. Actually, motor drive assembly 169 is mounted upon one leg (not shown) of lower universal joint 167, with the other leg 179 being inserted into hole 181 (see Figure 9) of the casting 129 and affixed firmly to casting 129 as a support for motor assembly 169 and universal joint assembly 167. Within the lower universal joint assembly, however, the universal joint itself, i.e., universal joint 183 (located within assembly 167 and shown partly in Figure 12) is freely movable.

Servo motor unit 175 is coupled, via gear assembly 177, to ball screw 171 for driving or applying a torque to the ball screw in response to receipt by the motor 175 of a drive voltage (e.g., via lead 172) from the servo amplifier 174 of control circuit 71 (see Figure 2A) responding to a signal generated by a focus detector apparatus such as apparatus 30. Ball screw 171 is coupled, via gear assembly 177, to motor unit 175 and to lower universal joint assembly 167. Ball screw 171 is freely swivelable with respect to the center of universal joint 183. Universal joint 183 acts to prevent gear assembly 177 from rotating whenever a torque is applied by motor 175 to ball screw 171, via gear assembly 177.

As shown in Figure 12, second or upper universal joint assembly 173 comprises a ball nut retainer frame 184, a ball nut 185 screwed into retainer 184, a universal joint 187 and a tower lift bar 189. Except for having a hole 188 drilled through the center of universal joint 187 to permit passage of ball screw 171, the upper universal joint is idential to lower universal joint 183. Ball nut retainer 184 has a threaded hole 191 through which ball nut 185 is screwed. Ball nut 185, in turn, has a threaded hole 192 and return ball track (not shown) through which balls circulate and through which ball screw 171 is screwed. Ball nut 185 also has a threaded exterior for mating with threaded hole 191.

Spherical ended pins 197 and V-block 195 are a part of the tower portion of lens positioning apparatus 107. As shown in Figures 9 and 12, spherical ended pins 197 and V-block 195 are affixed to vertical member 111 by bolts 193 and are supported by tower lift bar 189 for vertical movement thereon. In response to an amplified signal applied via lead 172 from amplifier 174, for example, motor unit 175 rotates ball screw 171, thereby driving ball nut 185 and retainer 184 and causing tower lift bar 183 and the tower portion (including pins 197 and V-block 195) to be moved vertically, the distance moved being in accordance with the magnitude of the differential signal and the direction of movement (up or down) being in accordance with the polarity of the differential signal.

On one side of tower lift bar 189, the tower portion is seated by means of V-block 195, and on two other sides of the tower lift bar (one side not shown), the tower portion is seated by means of pins 197 extending into V-grooves 199. This manner of seating permits easy removal and accurate

-17-

replacement of the tower portion of apparatus 107 from the drive portion of apparatus 107. The height of the ball screw 171 and the length of the block surfaces upon which the air bearings ride may be chosen to be any reasonable value (e.g., 3 inches) sufficient to permit easy removal or service of the stage or chuck without requiring removal of the projection lens.

Unlike prior-art systems, which utilize cables to move the projection lens assembly vertically and flextures to guide the assembly, lens positioning apparatus 107 utilizes rigid components such as ball screw and nut 171, 185, double universal joints 183,187, and five air bearings 119, 121, 123, 125, 127 to provide freedom of movement in a selected (vertical) direction, yet not overconstrain the system in other directions. As such, apparatus 107 represents a rugged, substantially non-sensitive apparatus (e.g., non-sensitive to environmental changes such as temperature, or vibration, or impact).

Referring back to Figure 1, there is shown a wafer chuck differential leveling apparatus 201 included in the optical focusing system of the present invention. Differential leveling apparatus 201 comprises a chuck, a chuck support plate, a drive means, an eccentric means and a constraining means. When actuated by signals from the detectors, the drive means actuates the eccentric means which operates in conjunction with the chuck support plate and with the constraining means to differentially level or elevate the plane of the chuck so as to position the top surface of the wafer normal to the optical axis of the system. This leveling action compensates for non-flat conditions of the wafer surface (for example for trapezoidally shaped wafers which have non-parallel top and bottom surfaces such that the top surface is slanted when the wafer is placed on a chuck as shown in Figure 13).

As indicated hereinabove, the lens positioning apparatus may be actuated to bring into focus a selected plane (normally the top surface of the wafer) or, more specifically, the center of a selected exposure area on the surface of the wafer. However, the wafer may be found to have as much as a 100 μ difference in height from one edge to another (as shown in Figure 13) and still satisfy the Semiconductor Equipment and Materials Institute's specifications. In such an event, if, for example, ten exposures were to be made across the surface of the wafer from edge to edge, then, for each exposure, there would be approximately a ten micron difference in elevation or height from edge to edge (side to side) of the exposure. But, as indicated hereinbefore, where the desired depth of focus of the projection lens 13 is in the range ± 1 micron, this would create a gross (approximately five times) out-of-focus condition on either side or edge of the exposure because, whereas the portion of the wafer surface in the center of the exposure may be brought into focus as described hereinbefore, the portion of the wafer surface on one side of the exposure would be out of focus by being too near projection lens 13, and the portion of the wafer surface on the other side of the exposure would be out of focus also, by being too far from projection lens 13. To bring the sides as well as the center of the exposure into focus, differential leveling apparatus 201 provides for differentially leveling the chuck. This differential leveling action brings the top surface of the wafer into a focus plane that is nominally common to all surface portions of the wafer which lie within the selected exposure area.

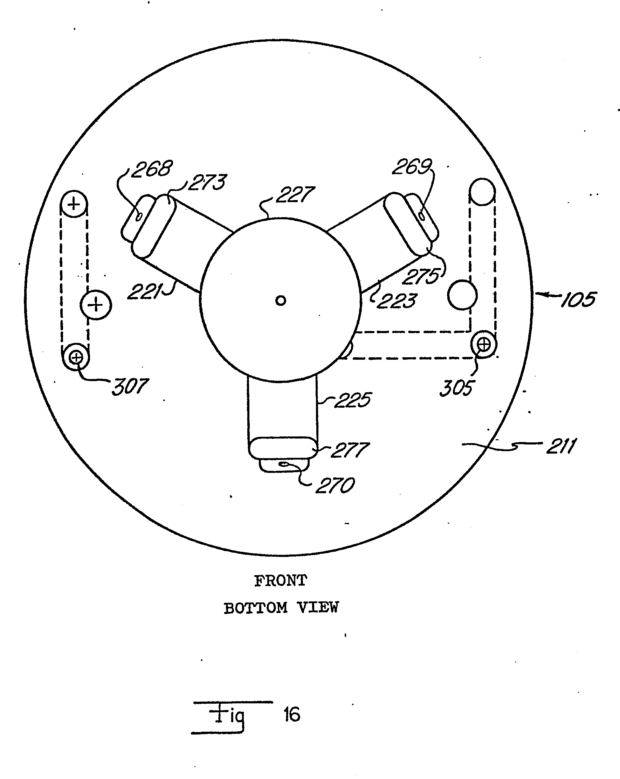

Differential leveling is performed without having the chuck translate in the X or Y direction or rotate in the X-Y plane about the Z axis. The chuck is made to have three degrees of freedom of movement (i.e., translation along the Z axis, and rotation about the X and Y axes which may be regarded as equivalent to translation along the Z axis, with the Z axis positioned at three points 203, 205, 207 shown in Figure 14, the points being located in the X-Y plane at a selected radius 60°, 180° and 300°, respectively, from the Y axis). The chuck, with the wafer having previously been secured (by vacuum) to its top surface and positioned relative to the optic axis of the system, is moved at points 203, 205 and 207 in a manner equivalent to translation along axes $Z_1$, $Z_2$, $Z_3$.

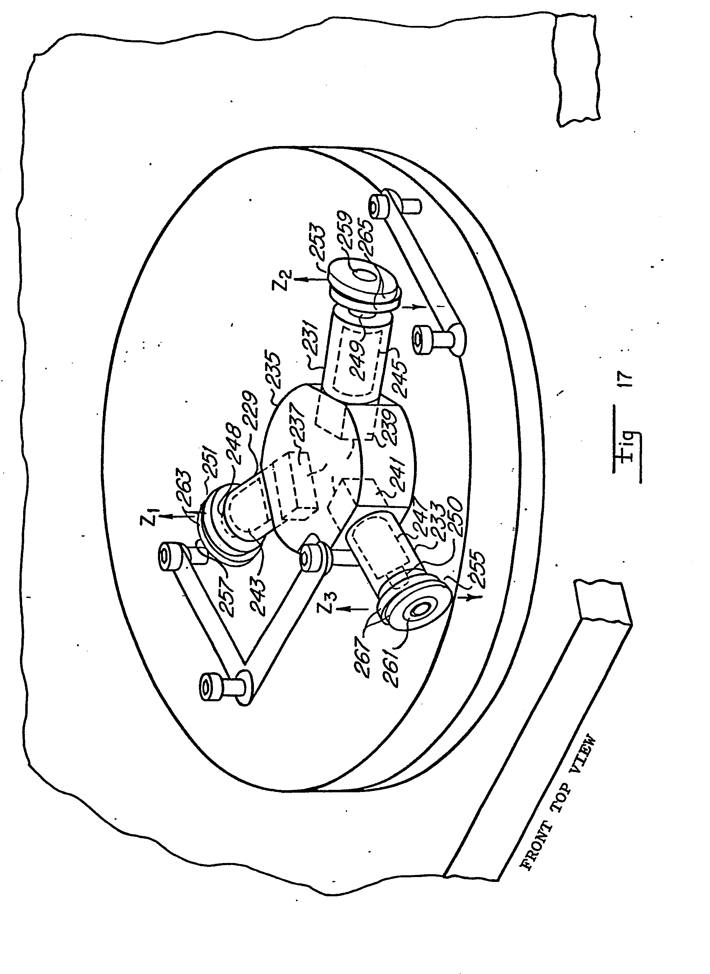

As shown in Figures 15 and 16, a chuck support plate 209 is provided beneath chuck 105 (chuck 105 differs from chuck 34 shown in Figure 2A in that chuck 105 includes wafer chuck differential leveling apparatus 201 not present in chuck 34). This plate 209 mates with the bottom portion 211 of chuck 105 in a manner which permits elongated structures 213, 215, 217 and substantially round structure 219 to mate with corresponding structures 221, 223, 225 and 227 to form enclosures 229, 231, 233 and 235 (see Figure 17) defining cavities therein. Disposed within the enclosures, as shown in Figure 17, are three small servo motors 237, 239, 241 (e.g., 12 millimeters in diameter), coupled to three small (e.g., 12 millimeters in diameter) gear assemblies 243, 245, 247 (e.g., 96:1 gear assemblies). The gear assemblies, in turn, are coupled, via three shafts 248, 249, 250 (e.g., each shaft being 2 millimeters in diameter) to three double (paired) eccentrics 251, 253, 255. Each of these double eccentrics 251, 253, 255 enclose a pair of ball bearing assemblies 257, 259, or 261, the ball bearing assemblies being disposed about shafts 248, 249, 250 to permit easy rotation of the double eccentrics about those shafts.

Each eccentric of each double eccentric is eccentrically offset, for example, 0.005 inch in a direction opposite to the other eccentric of the same double eccentric so that as the motor and gear assembly rotates one eccentric of each double eccentric travels in an upward direction and the other travels in a downward direction. A small tire or roller 263, 265, 267 is mounted about each eccentric of each double eccentric. As the tires rotate, the double eccentrics 251, 253, 255 travel up and down with one tire of each double eccentric contacting a bottom portion of chuck 105 at a spot 268, 269 or 270 (see Figure 16), and the other tire of the same double eccentric contacting the top of chuck support plate 209 at a spot 271, 272, or 274 (see Figure 15).

Proximate to each contact spot, an end milled cavity 273, 275, or 277 is defined to provide clearance for the oppositely acting roller to bypass that contact spot and to actually travel below the center line corresponding to the axial center of shaft 248, 249, or 250. By being able to contact the chuck at the three points 268, 269, and 270 (corresponding to points 203, 205, and 207 in Figure 14) and to travel in upward and downward directions, the eccentrics 251, 253, 255 provide a differential leveling action (i.e., a leveling action at three different points on the chuck and, hence, at three different points on the surface of a wafer placed thereon).

In the actual leveling operation or procedure, the focus detector apparatus 11 (see Figure 1) may be used to first bring into focus or to focus the center of the wafer (e.g., a 100 mm diameter wafer) by positioning the lens positioning apparatus 107 so that the center of the wafer comes into focus, by then moving the stage successively so that the portion of the wafer surface corresponding to each of the three spots 203, 205, 207 of Figure 14 is positioned along the optic axis of the system, and by then, individually, bringing each of the three spots into focus by differentially leveling or elevating the chuck. Thus, as shown in Figures 2A, 2C, 12 and 17, after the center of the wafer is positioned along optic axis 14, motor 175 moves the tower portion of lens positioning apparatus 107 and focuses the center of the wafer in response to an amplified differential signal received from detector unit 30 via amplifier circuit 73, switch 75, and lead 172. Thereafter, the wafer is positioned so that one of the three spots 203, 205, or 207 (for example spot 203) is positioned along the optic axis, and the motor 237 is then actuated to move chuck 105 up or down at that spot 203 by means of eccentric 251, thereby leveling the chuck at that spot so as to bring the wafer surface at that spot into focus in response to an amplified differential signal from detector unit 30 via control circuit 71 (actually, via amplifier circuit 73 and switch 75 of control circuit 71 shown in Figure 2C). In a similar fashion, spots 205 and 207 after being positioned along the optic axis would be leveled by eccentrics 253 and 255, respectively, in response to actuation of motors 239 and 241, respectively, by amplified differential signals received, via control circuit 71, from detector unit 30. Where four detector units (groups) are employed, as shown in Figure 8, the differential signals from the detector units may be averaged and amplified by amplifier unit 73 as shown in Figure 2D.

To maintain the Z axis position of lens positioning apparatus 107 constant during periods of time that switch 75 is not connected to lead 172 (i.e., when the optical focusing system is not controlling the focusing operation), a distance measuring transducer 200 may be utilized in conjunction with control circuit 206 as shown in Figure 18. An output signal from transducer 200 is applied, via switch 202, to a sample-and-hold circuit 204 each time lens positioning apparatus 107 is positioned
in response to amplified differential signals received, via
control circuit 71, from detector unit 30. After lens positioning
apparatus 107 is positioned, and switch 75 is disconnected from
lead 172, switch 202 is switched, thereby connecting the output
of distance measuring transducer 200 directly to amplifier 208.
Meanwhile, sample and hold circuit 204 holds the last voltage
output received from transducer 200 before the switching of switch 202.
Amplifier 208 acts as a comparator and amplifier and applies a
drive voltage through switch 210 (now closed) to lead 172,
thereby maintaining lens positioning apparatus 107 in its posi-
tion and maintaining the voltage from transducer 200 constant
in closed loop fashion. Such a distance measuring transducer
is commercially available as Linear Variable Differential
Transformer, Catalog Part No. 050H-DC from, for example, Schaevitz
Engineering Corporation, in Cambden, New Jersey.

As indicated hereinbefore, three points (203, 205, 207, in
Figure 14) on a wafer surface may be made to coincide with
image plane 45 of lens 13. However, as shown in Figure 20, wafer
surface 33 may in fact not be flat, but undulated or irregular.
Therefore, as the wafer is progressively positioned in different
image positions under lens 13, the wafer surface will, in general,
deviate from image plane 45 and will be out of focus. Thus,
when a step-and-repeat exposure mode of operation is employed, the lens positioning apparatus will again respond to inputs (amplified
differential signals) from the focus detection apparatus, and the tower and projection lens structure will track or follow the actual contour of the wafer surface 33.

Because the weight of the chuck acts downward upon the rollers, and the paired or double rollers are displaced sideways from one another a selected eccentric distance, a resulting torque loads the differential leveling apparatus causing it to be substantially backlash free (i.e., free from dead time or dead backlash space) when leveling directions are reversed.

In the foregoing, the manner in which the differential leveling apparatus levels a wafer is described, where the apparatus has only three degrees of freedom of movement. The manner in which the apparatus constrains the remaining three degrees of freedom of motion is described below.

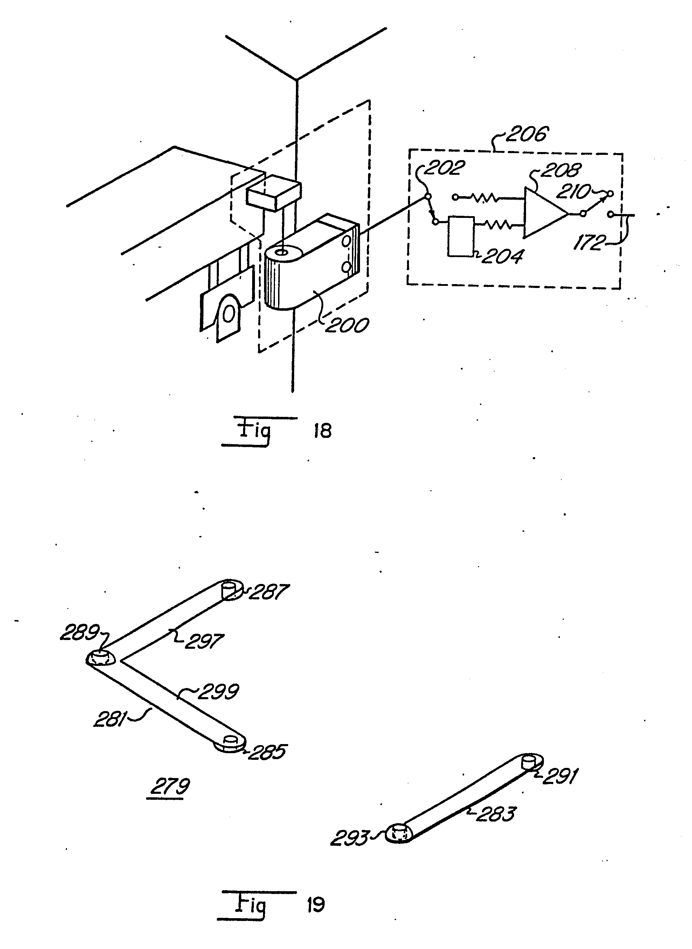

Referring now to Figure 19, there is shown constraining apparatus 279 comprising an L-shaped link member 281 (e.g., a Beryllium-copper leaf springofapproximately sixteen mils in thickness having two legs, each leg being approximately 1 3/4 inches in length) and an elongated link member 283. L-shaped link member 281 has hard soldered to its top and bottom surfaces three hemispherical balls 285, 287, 289, the two balls 285, 287 being hard soldered to the end portion of the bottom surface of the link member, and one ball 289 being hard soldered to the top surface at the apex of the link member. Also, two hemispherical balls are hard soldered to elongated link member 283, one ball 291 being soldered at one end to its bottom surface and the other ball 293 being soldered at the other end to its top surface.

As shown in Figures 15, 16, 17 and 19, ball 287, which has a hole therethrough for receiving a screw, is screwed into an elongated counter sink (tapped threaded hole) 295 formed in chuck support plate 209, counter sink 295 being elongated in a

-24-

direction orthogonal to leg 297 of L-shaped link member 281. Similarly, ball 285 is screwed into threaded, optionally elongated counter sink 301 such that leg 299 is orthogonal to the direction in which counter sink 301 is elongated. Counter sinks 295 and 301 are formed in chuck support plate 209 in a manner permitting the elongated direction of one counter sink to be orthogonal with respect to the other. Ball 291 of elongated link member 283 is screwed into a threaded hole 303 of chuck support plate 209.

Thereafter, the bottom portion 211 of chuck 105 is screwed down upon chuck support plate 209. Screws inserted via holes 305 and 307 in the bottom portion 211 of chuck 105 mate with threaded holes 289 and 293, respectively in chuck support plate 209, firmly securing bottom portion 211 to link members 281 and 283. When secured in this manner, the L-shaped and elongated link members 281 and 283 act to constrain chuck 105 from translational movement along the X or Y axis and from rotational movement in the X-Y plane about the Z axis.

**Dr.-Ing. Roland Liesegang**

Patentanwalt
European Patent Attorney

Sckellstrasse 1
D-8000 München 80
Telefon (089) 4 48 24 96

Telex 5214382 pali d
Telekopierer (089) 272 04 80, 272 04 81
Telegramme patemus münchen

Postscheck München 394 18-802
Hypobank München 6 400 194 333
Reuschelbank München 2 603 007

OPTIMETRIX CORPORATION

Mountain View, USA

EU 140 29

Claims

A system for positioning a utilization device

1. A system for positioning a utilization device (33,105), which forms part of an optical imaging system, parallel to a selected plane (X-Y), said system including a base structure (101), c h a r a c t e r i z e d  by a plurality of spaced drive means (237-255) for supporting the utilization device (33,105) for translational movement along a first axis (Z) normal to a plane (X-Y) of the base structure (101) and for rotational movement about second and third axes (X,Y) orthogonal to the first axis (Z) and parallel to said plane (X-Y) of the base structure (101); and constraining means (283,297,299), including the drive means (137-255), for kinematically constraining the utilization device (33,105) to move only along the first axis (Z) and about the second and third axes (X,Y).

2. A system as claimed in claim 1, c h a r a c t e r i z e d in that said drive means (237-255) comprises first, second and third drive means for moving the utilization device (33,105) along the first axis (Z), for rotating the utilization device, (33,105) about the second axis (X) and for rotating the utilization device (33,105) about the third axis (Y); and said constraining means (283,297,299) comprises three spring members for preventing rotation of the utilization device (33,105) about the first axis (Z) and for preventing movement of the utilization device (33,105) along the second and third axes (X,Y).

3. A system as claimed in claim 2, c h a r a c t e r i z e d in that two of said spring members (283,297,299) comprise an L-shaped spring member (281); the other of said spring members (283,297,299) comprises an elongated member (283); and said L-shaped and elongated members (281,283) are coupled to the utilization device (33,105).

4. A system as claimed in claim 1, 2 or 3, c h a r a c - t e r i ze d in that said plurality of spaced drive means (237-255) includes a plurality of eccentric means (251,253,255) coupled to the utilization device (33,105) at predetermined locations (268,269,270) equidistant from each other.

5. A system as claimed in claim 4, c h a r a c t e r i z e d in that each of said eccentric means (251,253,255) comprises a double eccentric having a pair of ball bearing assemblies (257,259,261) disposed about a shaft (248, 249,250), and further having a roller (263,265,267) mounted on each ball bearing assembly with the rollers on each pair of ball bearing assemblies (257,259,261) being oppositely displaced from each other by a selected distance.

6. A system as claimed in claim 5., c h a r a c t e r i z-
e d in that the rollers (263,265,267) on each of said
pairs of ball bearing assemblies (257,259,261) travel
upward and downward with one of those rollers in contact
with a bottom portion (211) of the utilization device
(33,105) at said predetermined locations (268,269,270)
to position the utilization device (33,105) parallel
to the selected plane (X-Y).

7. A system as claimed in claim 6., c h a r a c t e r i z-
e d in that the rollers (263,265,267) on each of said
pairs of ball bearing assemblies (257,259,261) travel
upward and downward with the other of those rollers in
contact with a top portion of an adjacent support member (209) at corresponding predetermined locations
(271,272,274) to move the utilization device (33,105)
relative to the support member (209) in positioning
the utilization device (33,105) parallel to the selected plane (X-Y).

8. A system as claimed in claim 4, 5., 6 or 7.,
c h a r a c t e r i z e d in that said plurality
of spaced drive means (237-255) further includes a
plurality of drive gear units (237 & 243, 239 & 245,
241 & 247) each coupled to a corresponding one of said
eccentric means (251,253,255) for driving that eccentric
means.

9. A system as claimed in claim 8, c h a r a c t e r i z-
e d in that said utilization device (33,105) is configured to mate with an adjacent support member (209)
for forming a plurality of enclosures (213,215,217)
each enclosing a corresponding one of said drive gear
units (237 & 243, 239 & 245, 241 & 247) and its
corresponding eccentric means (251,253,255).

10. A system as claimed in claim 8 or 9, c h a r a c - t e r i z e d in that said plurality of spaced drive means (237-255) comprises three in number coupled to the utilization device (33,105) at three predetermined locations (268,269,270) disposed one hundred and twenty degrees apart.

11. A system as claimed in any of the preceding claims 1 to 10, c h a r a c t e r i z e d in that said utili- zation device (33,105) comprises a chuck member (105) for holding a workpiece (33); and said system further includes focus detection means (11), coupled to the drive means (237-255), for controlling the drive means (237-255) to position the workpiece (33) parallel to the selected plane .

12. A system as claimed in claim 11, c h a r a c t e r i z- e d in that said focus detection means (11) comprises at least three focus detectors.

13. A system as claimed in any of the preceding claims 1 to 12, c h a r a c t e r i z e d in that the utiliza- tion device (33,105) is disposed on a movable stage (103) for movement therewith.

Fig 1

LIGHT FROM
IMAGING LIGHT SOURCE
(OFF DURING FOCUSSING)

Fig 2E

Fig 2B

Fig 2A

OPTICAL FIBERS

OPTICAL FIBERS

TO SERVO MOTOR

0097380

TO SERVO
MOTOR 175

TO SERVO
MOTOR 237

TO SERVO
MOTOR 239

TO SERVO
MOTOR 241

FROM
DETECTOR
UNIT 30

Fig 2C

TO SERVO
MOTOR 175

TO SERVO
MOTOR 237

TO SERVO
MOTOR 239

TO SERVO
MOTOR 241

FROM
FOUR-
DETECTOR
UNITS
(GROUPS)

Fig 2D

*Fig* 3

*Fig* 6

0097380

FROM
SOURCE 21

51

PORTION
OF
LIGHT
REFLECTED
FROM
WAFER
SURFACE

FROM
SOURCE 19

31

27

TO
CONTROL
CIRCUIT

29   59   25

23

$\overline{\text{Fig}}$ 4

165

129

157   119
141
139   131
149   127

147   155  145   121
137   123   133
125   123  135   143
163   133

$\overline{\text{Fig}}$ 10A

131
151
141        159
119

133
143
153        129
161  121
2"

$\overline{\text{Fig}}$ 10B

Fig 5

Fig 7

BEAM SPLITTERS
(4 EACH)

LIGHT SOURCES
(4 GROUPS)

EXPOSURE
BEAM REGION

DETECTOR
(4 GROUPS)

Fig 8

0097380

$\overline{\text{Fig}}$ 9

Fig 11

Fig 14

Fig 13

Fig 20

$\overline{\underline{\mathrm{Fig}}}$ 12

FRONT
TOP VIEW

Fig 15

0097380

FRONT
BOTTOM VIEW

$\overline{\mathrm{Fig}}$ 16

$Z_1$
263
251
257
248
229
243
235
237
231
$Z_2$
253
259
265
249
$Z_3$
267
261
247
233
250
239
241
245
255

FRONT TOP VIEW

Fig 17

0097380

Fig 18

279

Fig 19